(19) Europäisches Patentamt
European Patent Office
Office européen des brevets

(11) EP 3 273 231 A1

(12) **EUROPEAN PATENT APPLICATION**

(43) Date of publication:
24.01.2018 Bulletin 2018/04

(51) Int Cl.:
G01N 27/22 (2006.01)    G01R 27/26 (2006.01)

(21) Application number: 16180816.7

(22) Date of filing: 22.07.2016

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(71) Applicant: Ostbayerische Technische Hochschule Regensburg
93049 Regensburg (DE)

(72) Inventors:
• **Schubert, Martin Josef Wilhelm**
**93049 Regensburg (DE)**
• **Seign, Stefan**
**94350 Falkenfels (DE)**

(74) Representative: **Lucke, Andreas**
**Boehmert & Boehmert**
**Anwaltspartnerschaft mbB**
**Pettenkoferstrasse 22**
**80336 München (DE)**

(54) **ARRANGEMENT FOR MEASURING CAPACITANCE**

(57) The present invention is in the field of measuring capacitance of a measurement capacitor C. The measured capacitance can depend on humidity, for example on the humidity of soil. An arrangement for measuring the capacitance includes a first circuit and a second circuit, wherein the second circuit is adapted to provide a signal corresponding to the capacitance of the measurement capacitor C based on a signal provided by the first circuit system. More specifically, the first circuit includes at least two diodes connected in series, wherein a first port of the measurement capacitor C is connected to the contact between two of the diodes connected in series and a second port of the measurement capacitor C is connected to a signal line.

Fig. 6

**Description**

FIELD OF THE INVENTION

The present invention is in the field of measuring capacitance of a measurement capacitor C. In an example, the measured capacitance depends on humidity, for example on the humidity of soil, where hence soil humidity has impact on the measurement capacitor C. The present invention discloses an arrangement for measuring the capacitance comprising a first circuit and a second circuit, wherein the second circuit is adapted to provide a signal corresponding to the capacitance of the measurement capacitor C based on a signal provided by the first circuit.

BACKGROUND OF THE INVENTION

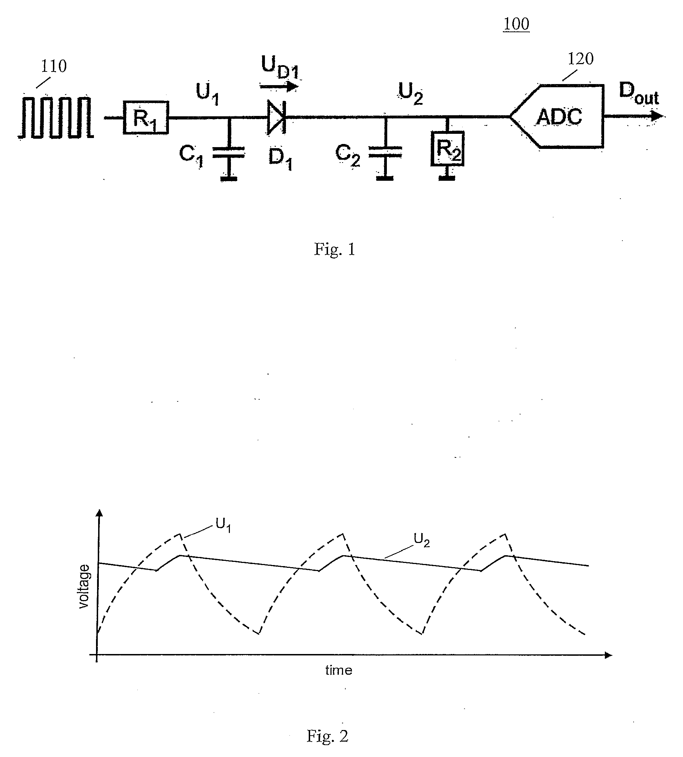

Measuring the capacitance of a measurement capacitor, for example to measure the humidity of soil, is typically performed by measuring time- or frequency-domain responses of a circuit including the measurement capacitor. For example, in the time-domain, the capacitance can be measured by observing the transient behavior of a circuit including the measurement capacitor, wherein the capacitor is repeatedly charged and discharged, for example to determine time-constants describing the transient behavior. Thus, the dynamics of the charging and discharging process can be used as an indicator for determining the capacitance. In this respect, Fig. 1 shows a typical arrangement 100 for measuring a capacitance $C_1$, for example to measure the humidity of soil determining the capacitance $C_1$. A square wave signal 110 is used for stimulating the charging and discharging process of the capacitor $C_1$. Note that here and at similar instances, the same symbol "$C_1$" is used to refer to both, the capacitor and its corresponding capacitance. Accordingly, the voltage at the capacitor $C_1$ represents a periodic voltage signal $U_1$, and as indicated in Fig. 2, the signal $U_2$ holds the amplitude of the signal $U_1$ with a slight voltage difference. For large values of capacitance $C_1$ the amplitude of the periodic voltage signal $U_1$ is small, because the transients are generated by charging and discharging a large capacitance $C_1$ and are thus bound by a large time-constant $R_1 \cdot C_1$. By contrast, for smaller values of capacitance $C_1$ the amplitude of the periodic voltage signal $U_1$ is large, because the transients are generated by charging and discharging a smaller capacitance $C_1$ and are thus bound by a smaller time-constant $R_1 \cdot C_1$. It follows that the capacitance $C_1$ is measurable by determining the amplitude of the generated periodic voltage signal $U_1$. For this purpose, Fig. 1 shows how a circuit including a diode $D_1$, a resistor $R_2$ and a capacitor $C_2$ can be coupled to the capacitor $C_1$ such as to measure the amplitude of the generated periodic voltage signal $U_1$. In this respect, the circuit ($D_1$, $R_2$, $C_2$) corresponds to an AM-demodulator circuit, a peak-detection circuit or a voltage regulation circuit known in the art. Thus, the output voltage $U_2$ of the AM-demodulator circuit corresponds to the value of the capacitance $C_1$ and can thus be used as a capacitance measurement result, which may also be converted by the illustrated A/D-converter 120 to a digital signal for digital processing. The document "Entwicklung eines kapazitiven Erdfeuchtesensors mit variabler Auflösung", Bachelor Thesis of Michael Oberacher, OTH Regensburg, March 2013, provides a detailed discussion and analysis of such arrangements for measuring the capacitance $C_1$.

It follows that the arrangement shown in Fig. 1 allows a simple and transparent approach to measure values of capacitance $C_1$, but the method provides only limited precision of measurement, in particular when a wide range of capacitance may be the subject of measurement. More specifically, for example in the case of measuring capacitances $C_1$ determining the humidity of soil, the capacitance $C_1$ can vary by a factor of $\varepsilon_{r,H2O} = 81$ (dielectric constant of water) depending on the degree of humidity varying from dry to wet, representing a wide range of capacitance $C_1$ which may be difficult to measure with sufficient precision using only a single frequency square wave signal 110. For example, if the measuring capacitance $C_1$ defines a large time-constant $R_1 \cdot C_1$, in comparison to the period of the square wave signal 110, the amplitude of the periodic voltage signal $U_1$ is small and changes only marginally when the measuring capacitance $C_1$ is being varied. In contrast, if the measuring capacitance $C_1$ defines a small time-constant $R_1 \cdot C_1$, in comparison to the period of the square wave signal 110, the amplitude of the periodic voltage signal $U_1$ reaches a saturation state, and thus changes only marginally when the measuring capacitance $C_1$ is being varied. Thus, in order to achieve a measurement sensitivity allowing sufficient precision of measurement, it may be required to adjust the period of the square wave signal 110, such as to correspond to the soil humidity being measured. Such a requirement represents an undesired compromise between sensitivity and usability of the measurement approach.

SUMMARY OF THE INVENTION

Accordingly, a problem underlying the invention is to provide an efficient scheme for measuring capacitances in a robust and precise manner, and also for a wide range of capacitances.

This problem is solved by the arrangement for measuring the capacitance of a measurement capacitor C as defined in claim 1. Preferable embodiments are defined in the dependent claims.

The arrangement of the invention comprises a first circuit and a second circuit, wherein the second circuit is adapted to provide a signal corresponding to the capacitance of the measurement capacitor C based on a signal provided by the first circuit.

More specifically, the arrangement for measuring the capacitance of the measurement capacitor C comprises:

- a signal line;
- a first circuit including at least two diodes and a measurement capacitor C, wherein the at least two diodes are connected in series, wherein a first port of the measurement capacitor C is connected to the contact between two of the diodes connected in series and a second port of the measurement capacitor C is connected to the signal line, wherein the first circuit has an input port connected to a first one of said diodes and an output port connected to the last one of said series of at least two diodes; and
- a second circuit coupled to the output port of the first circuit, wherein the second circuit comprises a measuring circuit with an output port for providing a signal corresponding to the capacitance of the measurement capacitor C based on a signal provided by the output port of the first circuit.

Hence, the first circuit includes at least two diodes which are connected in series. One port of the measurement capacitor C is connected to a connection point of two of the diodes. In other words, the connection point represents a contact between two of the diodes connected in series, wherein for example the cathode of a first diode is connected to the anode of a second diode, representing the connection of two adjacent diodes in the series of diodes. In this example, the respective port of the measurement capacitor is hence coupled to the cathode of the first diode and to the anode of the second diode. It follows that the measurement capacitor can be charged via the first diode, and discharged via the second diode, such as to generate an electric current flowing through the series of diodes in one direction. For this purpose, a signal line is coupled to the other port of the measurement capacitor. In this way, the voltage of the signal line can influence and/or control the charging and discharging process of the measurement capacitor, in particular to charge the measurement capacitor via the first diode while the second diode is reverse biased and thus not conducting; or to discharge the measurement capacitor via the second diode while the first diode is reverse biased and thus not conducting. It follows that a unidirectional electric current is generated in the series of diodes. Thus, the generated electric current flows in one direction through the series of diodes such as to generate a signal at the output port connected to the last one of the series of diodes. Because the current, and thus the signal, is generated by charging and discharging the measurement capacitor, the magnitude of the current, more specifically the average current of the output signal depends on the capacitance of the measurement capacitor. The below discussion provides examples including calculations explaining how the magnitude of the generated current is linked to the capacitance of the measurement capacitor being charged and discharged.

In order to convert the current signal provided at the output port of the first circuit to a capacitance measurement result, a second circuit comprising a measuring circuit is coupled to the output port of the first circuit. In this way, the second circuit receives a signal representing an average current as provided by the output port of the first circuit, and based on this signal provides a further output signal corresponding to the capacitance of the measurement capacitor C. As the signal provided by the first circuit is linked to a unidirectional average electric current having a magnitude corresponding to the charge being exchanged when charging and discharging the measurement capacitor, an average or low-frequency component of the signal reflects the average magnitude of charge exchange which is directly linked to the capacitance of the measurement capacitor. Thus, for example, a second circuit adapted to low-pass filter the signal provided by the first circuit can effectively determine the capacitance. Moreover, as the low-pass filtering may, for example, be performed by accumulating and averaging the signal provided by the first circuit for a predefined measurement interval, the measurement interval can be extended such as to enhance the precision of averaging, and thus to improve the sensitivity of measuring the capacitance. It follows according to the present invention that a capacitance measuring scheme is provided which allows adjusting the precision of measuring capacitance by low-pass filtering and/or averaging the output signal of the first circuit for a defined period of time, corresponding to a measurement interval. Thus, for example, if the precision of measurement needs to be enhanced, for example to cover a wider range of measurement capacitances, the length of the measurement interval can be extended until the desired sensitivity is achieved in the complete desired range.

Moreover, by using diodes and the voltage potential of the signal line to influence and/or control the charging and discharging process of the measurement capacitor, see discussion above, other control means, such as for example switching means and/or controlled transistor means can be avoided. This is advantageous because, for example, controlling switches to charge and discharge the measurement capacitor can require a complex control circuit for generating precisely timed switching control signals, for example to prevent simultaneously conductive adjacent switches resulting in simultaneous charging and discharging of the measurement capacitor, possibly overloading and/or damaging electric components of the arrangement. Such control circuits add to the complexity and cost of the arrangement, and are also more prone to failure and malfunctioning. Furthermore, the process of switching causes considerable noise in form of glitches known as clock-feed-through, originating from unavoidable intrinsic capacitances of metal-oxide-semiconductor field-effect transistors (MOSFETS) being used as switches. However, the diodes can be implemented to represent active diodes, preferably metal-oxide-semiconductor field-effect transistors (MOSFETS) or transmission gates, for example to avoid the diode voltage drop effects, which is particularly expedient for circuits operating under 3V; see further discussion below.

In an example, the input port of the first circuit is connected to a voltage source comprised by the arrangement. In this respect, as mentioned above, the input port is connected to a first one of said series of diodes, and by connecting a voltage source comprised by the arrangement to the input port, the measurement capacitor can be charged by the voltage source via the at least one diode separating the voltage source and the measurement capacitor, for example, by lowering the voltage potential of the signal line. The voltage source coupled to the input port of the first circuit can provide supply voltages including ground. This allows a simpler circuit, including fewer electric components, wherein the voltage potential of the signal line can be used for controlling the charging and discharging process of the measurement capacitor.

In a further example, the measuring circuit of the second circuit comprises a delta-sigma modulator adapted to operate the first circuit as part of its loop. In this way, the delta-sigma modulator can provide a modulated signal corresponding to the capacitance of the measurement capacitor C at an output port of the delta-sigma modulator. In other words, the delta-sigma modulator of the measuring circuit contributes to converting the signal provided at the output port of the first circuit by providing a modulated signal corresponding to the capacitance of the measurement capacitor C. In this regard, the delta-sigma modulator allows using a low-resolution quantizer unit for generating a modulated signal represented by a series of samples, wherein although the resolution of each of the samples is low, the series of samples can be filtered to compensate the underlying quantization noise, theoretically to any desired degree. In other words, for example by averaging or low-pass filtering the series of samples, the precision of measurement can be enhanced by lengthening the time-interval used for averaging or low-pass filtering the series of samples, for example by changing the time-interval of a counter unit. Thus, by lengthening the respective time-interval, the precision of measurement can be improved to theoretically any desired degree, enhancing the sensitivity and precision of the capacitance measurement arrangement.

For this purpose, the measuring circuit can further comprise a demodulator coupled to the output port of the delta-sigma modulator and adapted to low-pass filter the modulated signal. For example, the demodulator can comprise a digital counter or a low-pass filter, which can, for example, be implemented using digital logic or a computing unit comprising a processor and memory. The following description mentions further examples of implementing the demodulator.

As mentioned above, the measurement capacitor can be charged via a first diode, and discharged via a second diode, such as to generate an electric current flowing through the series of diodes in one direction. For this purpose, a signal line is coupled to a port of the measurement capacitor such as to influence and/or control the charging and discharging process of the measurement capacitor. In an example, the first circuit comprises a charge-pump coupled between the input port and the output port of the first circuit, wherein by applying a time-varying or alternating signal to the signal line, electrical charges are moved between the input port and the output port of the first circuit. In this respect, the time-varying or alternating signal applied to the signal line can have low-impedance and a predefined peak-to-peak amplitude, such as to further define the charging and discharging process of the measurement capacitor, allowing a simplified and more precise evaluation of the resulting charge current.

In an example, the charge-pump corresponds to a Dickson-charge pump, preferably a Dickson-charge pump comprising two diodes followed by an integrator, wherein the integrator preferably includes a capacitor $C_L$ coupled between the output port of the first circuit and ground. In a related example, the arrangement further comprises a discharge circuit, wherein the discharge circuit forms a part of the delta-sigma modulator and is adapted to control discharge of said integrator, preferably to discharge said capacitor of the integrator coupled to the output port of the first circuit. In this way, the integrator of the Dickson-charge pump can be used by both the Dickson-charge pump and the delta-sigma modulator, in particular to implement the aggregating "sigma" part of the delta-sigma modulator, which is controlled by the delta-sigma modulator such as to perform the modulation task, without requiring a separate integrator. Thus, this arrangement allows a compact and efficient approach to implement both the Dickson-charge pump and the delta-sigma modulator. In an example, the capacitor $C_L$ of the integrator is coupled to the output port of the first circuit such as to simplify the above inclusion of the integrator function into the control-loop of the delta-sigma modulator.

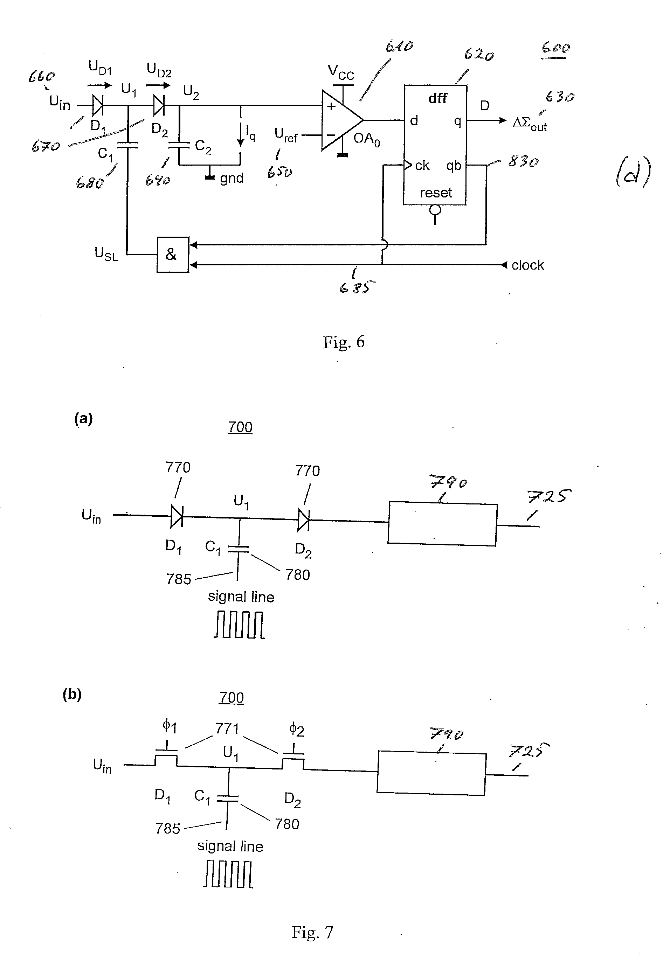

As mentioned above, the delta-sigma modulator can use a low-resolution quantizer unit for generating a modulated signal represented by a series of samples, wherein although the resolution of each of the samples is low, the series of samples can be filtered to compensate the underlying quantization noise. For the purpose of providing the quantizer, in an example, the delta-sigma modulator comprises an analog-to-digital converter (ADC), wherein the analog-to-digital converter (ADC) is adapted to translate the output value of the integrator into a digital number represented by one or more digital bits. In this example, the digital bits are latched into a memory with a clock signal to provide a time-discrete output signal representing the series of samples. In a related example, the arrangement further comprises a current source coupled to the output port of the first circuit integrator. Here, the current source is controlled by the state of the memory to charge or discharge the integrator, as discussed above. In an example, the current source is kept constant during a measurement phase and the charge stored in the integrator, for example the capacitor, is controlled by controlling the amplitude of the time-varying signal on the respective signal line. For this purpose, for example, a logic AND gate can be arranged to block a signal representing said state of the memory. More specifically, the current source in the delta-sigma loop is kept constant during the measurement and pulses on the respective signal line are suppressed as shown in Fig. 6(d).

In an example, the analog-to-digital converter (ADC) of the delta-sigma modulator is a 1-bit analog-to-digital converter (ADC). In fact, the resolution of each of the respective samples can be very low, because the series of samples can be filtered to compensate the underlying quantization noise, such as to achieve any desired measurement precision, see further discussion above. In a related example, the 1-bit analog-to-digital converter (ADC) comprises a comparator or an operational amplifier, wherein the comparator or the operational amplifier is preferably located in a computing device, a micro-controller or a signal processor.

In the example where the analog-to-digital converter (ADC) comprises a comparator, the delta-sigma modulator can further comprise a memory unit, for example a hold unit, preferably a flip-flop or a data flip-flop, wherein the memory unit is adapted to latch the output signal generated by the analog-to-digital converter (ADC), for example the error signal generated by the comparator, and to output the signal in a time-discrete manner at a clock frequency. This arrangement allows a compact and efficient constellation of components, in particular if the output of the memory unit represents the modulated signal provided by the delta-sigma modulator.

In a further example, the above discharge circuit comprising a controlled current source is adapted to be controlled by an output of the memory unit in a compact and efficient manner. For this purpose, the discharge circuit can, for example, comprise a resistor Rc and a diode in series, wherein the discharge circuit is coupled at one end to the integrator at the output port of the first circuit, and coupled at the other end to a negated output of the memory unit. The negated output of the memory unit provides a negated version of the output signal generated by the analog-to-digital converter (ADC) at a clock frequency.

Accordingly, an arrangement for measuring the capacitance of a measurement capacitor is provided, allowing measuring the capacitance in a robust and precise manner, also for wide ranges of capacitances. The measurement capacitor can represent any type of component, unit or substance providing a capacity for electric charge. In an example, the capacitance of the measurement capacitor C depends on humidity, in particular on the humidity of air, gases, substances, or soil.

As mentioned above, the measurement circuit can comprise a demodulator coupled to the output port of the delta-sigma modulator and adapted to low-pass filter the respective modulated signal. For this purpose, in an example, the demodulator comprises an analog low-pass filter, a digital low-pass filter, an integrator unit or a counter, adapted to perform low-pass filtering.

SHORT DESCRIPTION OF THE FIGURES

Fig. 1    shows a conventional arrangement for measuring a capacitance, for example to determine the humidity of soil representing a capacitor;

Fig. 2    shows a periodic voltage signal $U_1$ at the measurement capacitor when a square wave signal stimulates the charging and discharging process of the capacitor, and voltage signal $U_2$ which is proportional to the amplitudes of $U_1$;

Fig. 3    shows in part (a) a sigma-delta modulator and demodulator principle, in part (b) the corresponding conversion of an analog signal to a digital stream of samples, and in part (c) the arrangement of Fig 3(b) with a 1-bit (two-level) analog to digital conversion;

Fig. 4    shows in part (a) an inverter including an operational amplifier, in part (b) a sigmadelta modulator including a corresponding inverter, and in part (c) the sigma-delta modulator including a switched capacitor in lieu of resistor $R_1$ of part (b);

Fig. 5    shows in part (a) a Dickson Charge-Pump with diodes, in part (b) an equivalent circuit representing the Dickson Charge-Pump of Fig. 5(a), and in part (c) a Dickson Charge-Pump with transistors as active diodes;

Fig. 6    shows in part (a) an arrangement using a Dickson Charge-Pump for transforming a capacitance $C_1$ into an equivalent resistor, in part (b) the Dickson Charge-Pump transformed by using the equivalent circuit shown in Fig. 5(b), in part (c) the circuit of part (a) with the current source Iq realized as a resistor $R_c$ and a diode $D_3$ coupled in series and in part (d) the current source Iq is kept constant while pulses on a signal line $U_{SL}$ are omitted when necessary by having a logic AND gate block the signal when D = '1'; and

Fig. 7    shows in part (a) an arrangement for measuring capacitance including two diodes, and in part (b) the same arrangement wherein the diodes are realized as active diodes.

DESCRIPTION OF THE PREFERRED EMBODIMENTS

For the purposes of promoting an understanding of the principles of the invention, reference will now be made to the preferred embodiments illustrated in the drawings and specific language will be used to describe the same. It will nevertheless be understood that no limitation of the scope of the invention is thereby intended, such alterations and further modifications in the illustrated devices and method and such further applications of the principles of the invention as illustrated therein being contemplated therein as would normally occur now or in the future to one skilled in the art to which the invention relates.

Fig. 7 shows in parts (a) and (b) an arrangement 700 for measuring the capacitance of a measurement capacitor C 780 according to a preferred embodiment. The arrangement 700 can comprise a first circuit with an input port 735 and an output port 745 and a second circuit. The second circuit is adapted to provide a signal corresponding to the capacitance of the measurement capacitor C 780 based on a signal provided by the first circuit. For this purpose, the second circuit can comprise a measuring circuit 790 with an output port 725, wherein the measuring circuit 790 can comprise a delta-sigma modulator adapted to operate the first circuit as part of its loop. In this way, the delta-sigma modulator can provide a modulated signal corresponding to the capacitance of the measurement capacitor C 780 at an output port of the delta-sigma modulator.

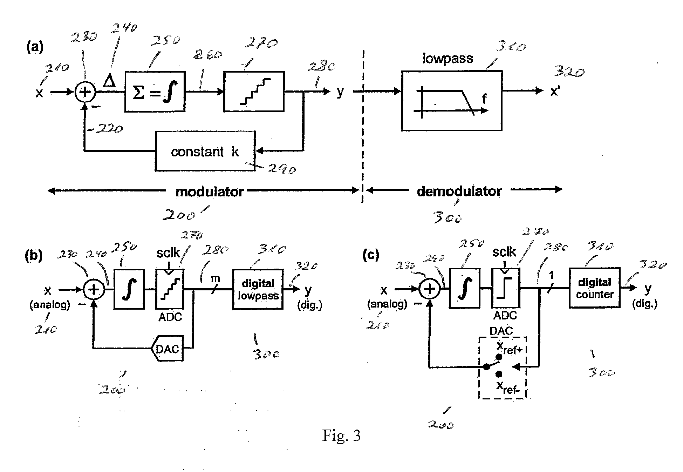

In order to promote understanding of the purpose and principle of using a delta-signal modulator, Fig. 3(a) shows a corresponding sigma-delta modulator 200 receiving a signal x 210, comparing the received signal x 210 to a feedback signal $k \cdot y$ 220 using a comparison unit 230, for example a difference-calculation unit 230, such as for example an adder 230, such as to generate a delta-error signal 240. The delta-error signal is fed to an integrator 250 for accumulating the delta-error signals 240 over time, and for providing a corresponding integrated signal 260 to a quantizer 270. The quantizer 270 provides an output signal y 280 at different discrete levels, which is fed back to the difference-calculation unit 230 such as to close the loop via a gain unit 290 amplifying or attenuating the output signal y by a factor k.

It follows that the sigma-delta modulator 200 receives a signal x 210 to generate an output signal y 280 including a series of samples having discrete values. As illustrated in Fig. 3(a), the original input signal x 210 can be re-constructed, at least approximately, by low-pass filtering the multi-level output signal y 280 of the sigma-delta modulator 200. Thus, the demodulator 300 includes a low-pass filter 310 and is adapted to receive the output signal y 280 of the sigma-delta modulator 200 and to low-pass filter the received signal such as to provide the reconstructed signal x' 320.

In other words, the delta-sigma modulator 200 allows using a low-resolution quantizer 270 for generating a modulated signal 280 represented by a series of samples, wherein although the resolution of each of the samples can be very low, the series of samples 280 can be filtered to compensate the underlying quantization noise, theoretically to any desired degree. For example, by averaging or low-pass filtering the series of samples 280, the precision of measurement can be enhanced by lengthening the time-interval used for averaging or low-pass filtering the series of samples 280, for example by changing the time-interval of a counter unit. Thus, by lengthening the respective time-interval, the precision of measurement can be improved to practically any desired degree, enhancing the sensitivity and precision of the underlying capacitance measurement arrangement.

Fig. 3(b) shows a corresponding sigma-delta modulator 200 and demodulator 300 wherein the signal x 210 received by the sigma-delta modulator 200 represents an analog signal compared by the difference-calculation unit 230 to a digital-to-analog converted output signal 280 of the quantizer 270. For this purpose, the quantizer 270 is clocked by the sampling-clock signal sclk. Thus, in this example, the low-pass filter 310 of the demodulator 300 represents a digital low-pass filter 310 generating a digital output signal 320 corresponding to the analog input signal x 210. It follows that the sigma-delta modulator 200 and demodulator 300 arrangement shown in Fig. 3(b) represents an analog-to-digital converter having a precision depending on the length of time-interval used for low-pass filtering the modulated signal 280 provided by the sigma-delta modulator 200. Thus, by lengthening the respective time-interval, the precision of measurement can be improved to theoretically any desired degree, enhancing the sensitivity and precision of the underlying capacitance measurement arrangement.

Similarly, Fig. 3(c) shows the sigma-delta modulator 200 and demodulator 300 of Fig. 3(a) for the case of using a 1-bit (two-level) quantizer 270. Accordingly, the digital-to-analog conversion of the output signal 280 of the quantizer 270 represents a switch for providing one of two reference values $X_{ref}+$, $X_{ref}-$ depending on the state of the output (bit) 280. Thus, the arrangement can be implemented using simple components for easier implementation, lower cost and improved transparency and reliability of the overall arrangement. For example, as the output signal 280 of the quantizer 270 represents a 1-bit digital stream, the low-pass filtering of the demodulator 300 can be implemented using a simple digital counter 310.

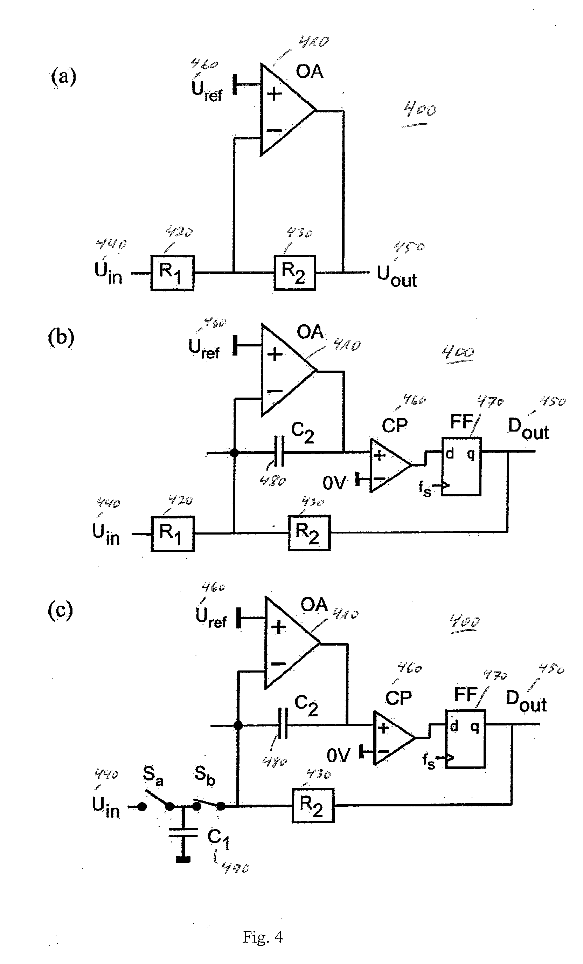

In order to provide the sigma-delta modulator 200 and demodulator 300 with an input signal allowing the measurement of a capacitance, Figs. 4(a) to 4(c) show the stepwise integration of the sigma-delta modulator into a circuit 400 representing an inverter with an operational amplifier 410. More specifically, Fig. 4(a) shows in an example the implementation of an analog inverter 400 using the operational amplifier 410 and two resistors ($R_1$, $R_2$) 420, 430. In this example, it can be shown that the input signal $U_{in}$ 440 is converted by the analog inverter into an output signal $U_{out}$

450 corresponding to the equation: $U'_{out} = -(R_2/R_1)U'_{in}$, wherein $U'=U-U_{ref}$, and wherein $U_{ref}$ 460 refers to a reference voltage potential used for comparison by the operational amplifier 410.

Fig. 4(b) shows in an example how the function of a sigma-delta modulator can be integrated into the inverter of Fig. 4(a). Here, a comparator 460 used as 1-bit quantizer is coupled to the input of a flipflop 470, wherein the flipflop 470 is clocked with sampling frequency $f_s$ to provide time-discretization with equidistant time-steps. Moreover, an integrator 480 is implemented by coupling a capacitor 480 to the error signal generated by comparison with the reference voltage potential $U_{ref}$ 460 as performed by the operational amplifier 410.

In other words, Fig. 4(b) shows how an analog inverter including an operational amplifier 410 can be used for implementing the functions of a sigma-delta modulator 200. Thus, by low-pass filtering the discrete output signal $U_{out}$ 450, for example as discussed above in connection with the demodulator 300, a result corresponding to the analog output value $U_{out}$ 450 shown in Fig. 1(a) is obtained. Hence, it follows from the above equation: $U'_{out} = -(R_2/R_1) U'_{in}$ that the respective sigma-delta modulator and demodulator arrangement can be used for measuring the input signal $U_{in}$ 440 or the resistance of $R_1$ 420.

In view of this, Fig. 4(c) shows how the resistor $R_1$ can be replaced by an equivalent resistor $R_{1eq}$ having a resistance corresponding to the capacitance of the measurement capacitor $C_1$. More specifically, the equivalent resistor $R_{1eq}$ is implemented by a circuit including switches $S_a$ and $S_b$, wherein the switches are adapted to subsequently transport charge packets via capacitor $C_1$ 490. The respective equivalent resistor can be shown to have an average resistance $R_{1eq}=1/(f_s \cdot C_1)$ wherein $f_s$ represents the switching frequency of $S_a$ and $S_b$. Thus, by measuring the resistance $R_{1eq}$ as explained above in the context of Fig. 4(b) and (c), the measured resistance value $R_{1eq}$ can be used for calculating the capacitance of the measurement capacitor $C_1$.

However, as the circuit shown in Fig. 4(c) uses switches $S_a$ and $S_b$ to implement the switched capacitor $C_1$, the resulting circuit is complicated to implement and operate, and is more prone to failure. For example, field effect transistors (FETs) can be used as switches, and may be preferable over bipolar junction transistors, in particular because accumulated base currents of bipolar junction transistors can be significant and can thus obscure the above charge transfer process of the switched capacitor $C_1$. However, the parasitic capacitances of field effect transistors (FETs) can result in noise effects known as clock-feedthrough deteriorating the measurement results. Moreover, it is essential that the operation of switches $S_a$, $S_b$ is timed in a very precise manner, requiring a complex control circuit for generating precisely timed switching control signals, to clock flipflop 470 shortly before opening switch $S_b$ and to prevent switches $S_a$, $S_b$ from being simultaneously conducting to avoid malfunctioning by corrupted charge balancing.

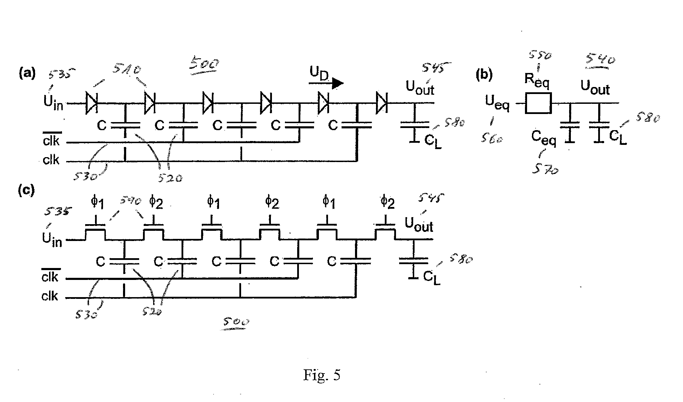

In this regard, Fig. 5(a) shows a Dickson Charge-Pump 500 implemented with diodes 510 rather than transistors, such as to generate an unidirectional current passing via a series of capacitors C 520. This circuit is, for example, proposed in the document "On-chip high-voltage generation in MNOS integrated circuits using an improved voltage multiplier technique", J. F. Dickson, IEEE J. Solid-State Circuits, vol. SC-11, pp. 374-378, June 1976. For this purpose, inverse clock signal lines 530 are coupled to ports of the capacitors C 520 such as to influence and/or control the charging and discharging process of the capacitors C 520. In other words, a charge-pump is coupled between the input port 535 and the output port 545, where by applying a time-varying or alternating signal to the inverse signal lines 530, electrical charges are moved between the input port 535 and the output port 545, without requiring any switching elements, such as for example controlled field effect transistors (FETs).

Fig. 5(b) shows a corresponding equivalent circuit 540 representing the Dickson Charge-Pump 500 shown in Fig. 5(a). Thus, the Dickson Charge-Pump 500 shown in Fig. 5(a) behaves as if an equivalent resistor $R_{eq}$ 550 is connected at one end to an equivalent voltage source $U_{eq}$ 560, and at the other end to a port of an equivalent capacitor $C_{eq}$ 570 connected in parallel to the load capacitor $C_L$ 580 shown in Figs. 5(a) to (c). As explained in the document: "A dynamic analysis of the Dickson charge pump circuit", T. Tanzawa and T. Tanaka, IEEE J. Solid-State Circuits, vol. 32, pp. 1231-1240, Aug. 1997, the corresponding values of $U_{eq}$, $R_{eq}$ and $C_{eq}$ can be calculated as follows:

$$U_{eq} = U_{in} + N\Delta U_{clk} - (N+1)U_D$$

$$R_{eq} = \frac{N}{f_S C}$$

$$C_{eq} = \begin{cases} \dfrac{4N^2+3N+2}{12(N+1)} C & for \quad even \quad N \\[3mm] \dfrac{4N^2-N-3}{12N} & for \quad odd \quad N \end{cases}$$

wherein N represents the number of capacitors C 520 included in the series of capacitors, $\Delta U_{clk}$ represents the voltage difference induced by the clock signal lines 530, and $U_D$ represents the voltage drop over each of the forward-biased diodes (see Fig. 5(a)). In this respect, the Dickson Charge-Pump 500 can also be implemented using field effect transistors (FETs) 590 as active diodes rather than the diodes 510, such as to avoid the diode voltage drop effect, which is particularly expedient for circuits operating under 3V. In other words, the diodes can represent active diodes. Such an arrangement is shown in Fig. 5(c), wherein the field effect transistors (FETs) 590 are also controlled by the gate voltages $\phi_1$, $\phi_2$. Moreover, Fig. 7 shows a corresponding example of a charge pump, wherein part (a) shows an implementation using two diodes 770, and part (b) shows a corresponding implementation wherein the two diodes represent active diodes 771, for example, transistors. In both cases, the second port of the measurement capacitor $C_1$ 780 is coupled to a signal line 785 such as to influence and/or control the charging and discharging process of the measurement capacitor $C_1$ 780.

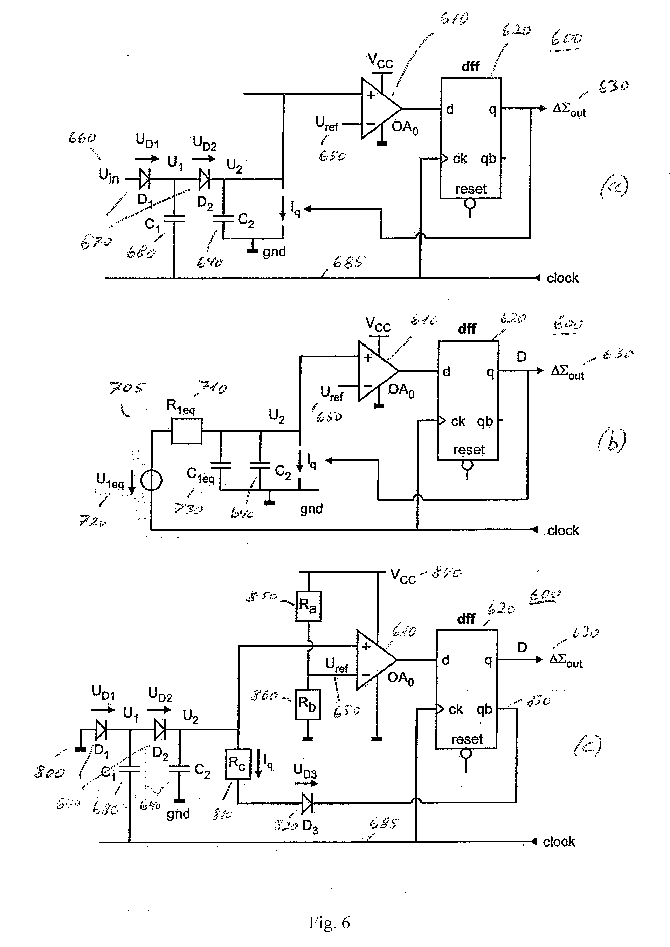

Accordingly, Fig. 6 shows how the above Dickson Charge-Pump 500 can be implemented with diodes 510 such as to omit the switches of the switched capacitor $C_1$, $S_a$, $S_b$ shown in Fig. 4(c).

More specifically, Fig. 6(a) shows a circuit 600 implementing a sigma-delta modulator by using the concept of applying an analog inverter as shown in Figs. 4(a) to (c). Hence, a comparator or an operational amplifier 610 is coupled to the input of a flipflop 620, wherein the flipflop is 620 operated by a 'clock' signal 685 such as to provide the function of a 1-bit quantizer; see the discrete output signal $\Delta\Sigma_{out}$ 630. In this respect, the 'clock' signal 685 is also coupled to the second port of the measurement capacitor 680 such as to provide the signal line 685 discussed above. Moreover, an integrator 640 is implemented as a capacitor and is coupled to the operational amplifier 610 for comparison with the reference voltage potential 650. Moreover, the discrete output signal $\Delta\Sigma_{out}$ 630 is used for controlling a discharge current Iq applied to discharge the integrator 640. In this way, a closed loop is provided for implementing the functions of the sigma-delta modulator. It follows that by low-pass filtering the discrete output signal $\Delta\Sigma_{out}$ 630, for example as discussed above in connection with the demodulator 300, a result corresponding to the equivalent electrical resistance coupling the input signal $U_{in}$ 660 to a port of the capacitor 640 is provided.

As explained above, the measured equivalent electrical resistance can be used for measuring the capacitance of the measurement capacitor $C_1$. For this purpose, in Figs. 6(a) to (c), a Dickson Charge-Pump is implemented with diodes 670 rather than using the switches illustrated in Fig. 4(c). Fig. 6(b) shows the above discussed equivalent circuit 705 of the Dickson Charge-Pump, wherein the equivalent resistor $R_{1eq}$ 710 is connected at one end to an equivalent voltage source $U_{1eq}$ 720, and at the other end to a port of an equivalent capacitor $C_{1eq}$ 730 connected in parallel to the integrator capacitor $C_2$ 640; see the corresponding above equations describing the equivalent circuit shown in Fig. 5(b), wherein for the case $N=1$, the equivalent voltage source is defined as $U_{1eq} = U_{in}+\Delta U_{clk}-2\cdot U_D$ resulting in the equivalent resistance $R_{1eq} = 1/(f_s\cdot C_1)$, wherein $f_s$ represents the clock frequency of the respective clock signal coupled to the measurement capacitor $C_1$.

In this way, a measurement circuit is provided which does not require switches $S_a$ and $S_b$ for implementing the respective switched capacitor $C_1$. It follows that the resulting circuit is less complicated to implement and operate, and is less prone to failure; see above discussion on further advantages related to replacing the switches $S_a$ and $S_b$ with a Dickson Charge-Pump using diodes.

Fig 6(c) shows the same Dickson Charge-Pump being implemented to form a sigma-delta modulator with an improved arrangement of components. More specifically, in Fig. 6(c) the input signal $U_{in}$ 800 is grounded to simplify the circuit by omitting a connection to a voltage source. Moreover, the discharge current Iq is generated by coupling a discharge resistor $R_c$ 810 to the flipflop 620 via a discharge diode 820. In this way, the discharge diode 820 prevents charging of the integrator 640 via the discharge resistor $R_c$ 810. The discharge resistor $R_c$ 810 is coupled to an output 830 of the flipflop 620 providing a negated version of the discrete output signal $\Delta\Sigma_{out}$ 630 representing a quantized signal. In this way, a very compact and efficient arrangement of components can be used for implementing the respective control of the discharge current Iq, for example by using conventional components, such as for example conventional flipflops. In this example, the discharge current Iq can be described as $Iq = D\cdot V_{CC}\cdot(U_2-U_{D3})/Rc$ wherein $V_{CC}$ 840 represents the supply voltage of the circuit 600, $U_{D3}$ represents to voltage drop of the discharge diode 820 in the forward-biased condition, and D takes the values 0 or 1 depending on the state of the negated output 830 of the flipflop 620. Moreover, as $N=1$, the equivalent capacitor $C_{1eq}$ 730 shown in Fig. 6(b) can be omitted, further simplifying the design of the overall circuit. Moreover, in order to provide the reference voltage potential $U_{ref}$ 650, two additional resistors $R_a$ 850 and $R_b$ 860 are connected as a voltage division circuit between ground and the supply voltage $V_{CC}$ 840.

It follows that Fig. 6(c) shows a very compact, robust and cost efficient arrangement for implementing a sigma-delta modulator, wherein the arrangement further achieves the above benefits of using the Dickson Charge-Pump. In fact, the arrangement shown in Fig. 6(c) only requires three resistors $R_a$ 850, $R_b$ 860, $R_c$ 810, three diodes $D_1$ 670, $D_2$ 670, $D_3$ 820, a capacitor $C_2$ 640 and a comparator including the operational amplifier 610. As explained above, the measurement capacitor $C_1$ 680 represents the capacitor subject to capacitance measurement. Fig. 6(d) shows a related arrangement for implementing the sigma-delta modulator, wherein the current source Iq is kept constant while pulses on a signal line $U_{SL}$ are omitted when necessary. For this purpose, a logic AND gate is arranged to block the signal when D = '1'.

Alternatively, digital components or units can be used for implementing or performing the above tasks of the circuit 600. For example, the microcontroller MSP430F2274 described in http://www.ti.com/product/msp430f2274 includes a comparator unit which can be used as a replacement for the operational amplifier 610.

In either way, by using the sigma-delta modulator and demodulator scheme discussed above, a compact, efficient, robust, and linear circuit arrangement can be provided for measuring the capacitance of the measurement

capacitor $C_1$ with high precision. In this example, a small measurement capacitance $C_1$ results in a low number of pulses being generated at the discrete output port $\Delta\Sigma_{out}$ 630 of the sigma-delta modulator. Thus, the smallest measurable capacitance is defined by underlying parasitic capacitances which may affect the measurement, and also by the ability of the arrangement to detect the rare pulses at the discrete output port $\Delta\Sigma_{out}$ 630. Thus, for example, it is generally possible to enhance the measurement sensitivity by increasing the counter length of a counter implemented in the demodulator. Further, the largest measurable capacitance $C_{1max}$ is limited by the largest discharge current $I_{q,max}$ supported by the circuit $I_{q,max} = (U_{1eq}-U_2) \cdot f_s \cdot C_{1max}$.

The embodiments described above and the accompanying figures merely serve to illustrate the method and devices according to the present invention, and should not be taken to indicate any limitation thereof. The scope of the patent is solely determined by the following claims.

LIST OF REFERENCE SIGNS

| | |
|---|---|
| 100, | arrangement for measuring a capacitance |
| 700, 110, | square wave signal |
| 120 | analog-to-digital-converter |
| 200, | sigma-delta modulator |
| 210, | input signal |
| 440, 535, 660, 735, 800, 220, | feedback signal |
| 230, | comparison unit |
| 240, | delta-error signal |
| 250, | integrator |
| 480, 640, 260, | integrated signal |
| 270, | quantizer |
| 280, | output signal |
| 450, 545, 630, 745, 830, 290, | gain unit |
| 300, | demodulator |
| 310, | low-pass filter |
| 320, | reconstructed signal |
| 400, | circuit |
| 600, 410, | operational amplifier |
| 610, 420, | resistor |
| 430, 850, 860, 460, | reference voltage potential |
| 650, 470, | flipflop |
| 620, 490, | measurement capacitor |
| 680, 780, 500, | Dickson Charge-Pump |
| 510, | diode |
| 670, 770, 520, | capacitor |
| 530, | clock signal lines |
| 685, 785, 540, | equivalent circuit |
| 705, 550, | equivalent resistor |
| 710, 560, | equivalent voltage source |
| 720, 570, | equivalent capacitor |
| 730, 580, | load capacitor/integrator |
| 590, | field effect transistor/active diode |
| 771, 790, | measuring circuit |
| 810, | discharge resistor |
| 820, | discharge diode |
| 840, | supply voltage source |
| 725, | output port of the measuring circuit |
| 735, | input port of the first circuit |
| 745, | output port of the first circuit |

**Claims**

1.  An arrangement for measuring capacitance (700), comprising:

    a signal line (685, 785);
    a first circuit including at least two diodes (670, 770) and a measurement capacitor (680, 780), wherein the at least two diodes (670, 770) are connected in series, wherein a first port of the measurement capacitor (680, 780) is connected to the contact between two of the diodes (670, 770) connected in series and a second port of the measurement capacitor (680, 780) is connected to the signal line (685, 785), wherein the first circuit has an input port (535, 660, 735) connected to a first one of said diodes (670, 770) and an output port (545, 745) connected to the last one of said series of at least two diodes (670, 770); and
    a second circuit coupled to the output port (545, 745) of the first circuit, wherein the second circuit comprises a measuring circuit (790) with an output port (630, 745) for providing a signal corresponding to the capacitance of the measurement capacitor (680, 780) based on a signal provided by the output port (545, 745) of the first circuit.

2.  The arrangement (700) according to claim 1, wherein the input port (535, 660, 735) of the first circuit is connected to a voltage source comprised by the arrangement (700), wherein the voltage source can provide supply voltages and/or ground.

3.  The arrangement (700) according to claim 1 or 2, wherein the measuring circuit (790) comprises a delta-sigma modulator (200, 600) adapted to operate the first circuit as part of its loop such as to provide a modulated signal corresponding to the capacitance of the measurement capacitor (C) at an output port (630) of the delta-sigma modulator (200, 600).

4.  The arrangement (700) according to claim 3, wherein the measuring circuit (790) further comprises a demodulator (300) coupled to the output port (630) of the delta-sigma modulator (200, 600) and adapted to low-pass filter (310) the modulated signal, wherein the demodulator (300) is preferably implemented using digital logic or a computing unit comprising a processor and memory.

5.  The arrangement (700) according to any of claims 1 to 4, wherein the first circuit comprises a charge-pump (500) coupled between the input port (535) and the output port (545) of the first circuit, wherein by applying a time-varying or alternating signal to the signal line (530, 685, 785), electrical charges are moved between the input port (535) and the output port (545) of the first circuit, wherein the time-varying or alternating signal (530, 685, 785) preferably has low-impedance and a predefined peak-to-peak amplitude.

6.  The arrangement (700) according to claim 5, wherein the charge-pump corresponds to a Dickson-charge pump (500), preferably a Dickson-charge pump (500) comprising two diodes (520, 670) followed by an integrator (580, 640), wherein the integrator (580, 640) preferably includes a capacitor coupled between the output port (545) of the first circuit and ground.

7.  The arrangement (700) according to claim 6, further comprising a discharge circuit (610, 810, 820), wherein the discharge circuit (610, 810, 820) forms a part of the delta-sigma modulator (200) and is adapted to control discharge of said integrator (640), preferably to discharge said capacitor of the integrator (640) coupled to the output port (545) of the first circuit.

8.  The arrangement (700) according to claims 6 or 7, wherein the delta-sigma modulator (200) comprises an analog-to-digital converter (ADC), wherein the analog-to-digital converter (ADC) is adapted to translate the output value of the integrator (640) into a digital number represented by one or more digital bits, wherein these digital bits are latched into a memory (620) with a clock signal to provide a time-discrete output signal (630).

9.  The arrangement (700) according to claim 8, further comprising a current source (610) adapted to be controlled by the state of the memory (620) to charge or discharge the integrator (640) and coupled to the output port (545) of the first circuit integrator, wherein the current source is preferably kept constant during a measurement phase and charge in the integrator (580, 640) is controlled by controlling the amplitude of the time-varying signal on the signal line (530, 685, 785).

10. The arrangement (700) according to claim 8 or 9, wherein the analog-to-digital converter (ADC) is a 1-bit analog-to-digital converter (ADC) (615), wherein the 1-bit analog-to-digital converter (ADC) comprises a comparator or an operational amplifier (OA), wherein the comparator or the operational amplifier (OA) is preferably located within a computing device, a micro controller or a signal processor.

11. The arrangement (700) according to claim 10, wherein the delta-sigma modulator (200) further comprises a memory unit (620), preferably a flip-flop, further preferred a data flip-flop, wherein the memory unit (620) is adapted to latch the output signal (630) generated by the analog-to-digital converter (ADC), and to output the latched signal in a time-discrete manner at a clock frequency, further preferred wherein the output of the memory unit (620) represents the modulated signal (630) provided by the delta-sigma modulator (200).

12. The arrangement (700) according to claim 11, wherein the discharge circuit comprises a controlled current source (610) adapted to be controlled by an output of the memory unit (620), wherein the discharge circuit preferably comprises a resistor (810) and a diode (820) in series, wherein the discharge circuit is coupled at one end to the integrator (640) at the output port (545) of the first circuit, and coupled at the other end to a negated output (830) of the memory unit (620), wherein the negated output (830) of the memory unit (620) provides a negated version of the output signal (630) generated by the analog-to-digital converter (ADC) at a clock frequency.

13. The arrangement (700) according to any of the preceding claims, wherein any of the diodes (670, 770) is realized as active diodes (590, 771), preferably realized as metal-oxide-semiconductor field-effect transistors (MOSFETS) or transmission gates.

14. The arrangement (700) according to any of the preceding claims, wherein the capacitance of the measurement capacitor (680, 780) depends on humidity, in particular on the humidity of air, gases or substances, further preferred on the humidity of soil.

15. The arrangement (700) according to any of claims 4 to 14, wherein the demodulator (300) coupled to the output port (630) of the delta-sigma modulator (300) comprises an analog low-pass filter (310), a digital low-pass filter, an integrator unit, or a counter adapted to perform low-pass filtering.

Fig. 1

Fig. 2

**(a)**

$$\Sigma = \int$$

constant k

modulator — demodulator

Fig. 3

Fig. 4

Fig. 5

Fig. 6

Fig. 6

**(a)**

700

signal line

**(b)**

700

signal line

Fig. 7

Europäisches
Patentamt

European
Patent Office

Office européen
des brevets

# EUROPEAN SEARCH REPORT

**Application Number**

EP 16 18 0816

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | Aaron G1 Podbelski: "Cypress' CapSense Sigma-Delta Algorithm Cypress Semiconductor White Paper", , 13 November 2007 (2007-11-13), XP055333088, Retrieved from the Internet: URL:http://www.cypress.com/file/73326/download [retrieved on 2017-01-09] * pages 2,3; figures 2-4 * | 1-15 | INV. G01N27/22 G01R27/26 |
| Y | US 8 547 114 B2 (KREMIN VIKTOR [UA]) 1 October 2013 (2013-10-01) * column 16, line 64 - column 23, line 52; figures 6-8 * | 1-15 | |
| Y | US 6 366 099 B1 (REDDI M MAHADEVA [US]) 2 April 2002 (2002-04-02) * column 4, line 43 - column 5, line 59 * * column 7, line 32 - column 8, line 20; figures 1a,1d * | 1-15 | |
| Y | Tutorial 725: "DC-DC Conversion Without Inductors", , 22 July 2009 (2009-07-22), XP055333110, Retrieved from the Internet: URL:http://pdfserv.maximintegrated.com/en/an/AN725.pdf [retrieved on 2017-01-09] * "Charge Pumps- A General description", 2; figures 1,3 * | 1-15 | TECHNICAL FIELDS SEARCHED (IPC) G01N G01R |
| Y | US 2007/046299 A1 (HARGREAVES KIRK [US] ET AL) 1 March 2007 (2007-03-01) * paragraphs [0022] - [0027]; figure 1A * | 1-15 | |

The present search report has been drawn up for all claims

| Place of search | Date of completion of the search | Examiner |
|---|---|---|
| Munich | 10 January 2017 | Stussi, Elisa |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 16 18 0816

This annex lists the patent family members relating to the patent documents cited in the above-mentioned European search report.
The members are as contained in the European Patent Office EDP file on
The European Patent Office is in no way liable for these particulars which are merely given for the purpose of information.

10-01-2017

| Patent document cited in search report | | Publication date | Patent family member(s) | | Publication date |
|---|---|---|---|---|---|
| US 8547114 | B2 | 01-10-2013 | US | 2008111714 A1 | 15-05-2008 |
| | | | US | 2012043973 A1 | 23-02-2012 |
| | | | US | 2013278447 A1 | 24-10-2013 |
| | | | US | 2016004354 A1 | 07-01-2016 |
| US 6366099 | B1 | 02-04-2002 | NONE | | |
| US 2007046299 | A1 | 01-03-2007 | US | 2007046299 A1 | 01-03-2007 |
| | | | US | 2008048679 A1 | 28-02-2008 |
| | | | US | 2008048680 A1 | 28-02-2008 |
| | | | US | 2009039902 A1 | 12-02-2009 |
| | | | US | 2010148806 A1 | 17-06-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Entwicklung eines kapazitiven Erdfeuchtesensors mit variabler Auflösung. *Bachelor Thesis of Michael Oberacher, OTH Regensburg,* March 2013
- **J. F. DICKSON.** On-chip high-voltage generation in MNOS integrated circuits using an improved voltage multiplier technique. *IEEE J. Solid-State Circuits,* June 1976, vol. SC-11, 374-378

- **T. TANZAWA ; T. TANAKA.** A dynamic analysis of the Dickson charge pump circuit. *IEEE J. Solid-State Circuits,* August 1997, vol. 32, 1231-1240